Europäisches Patentamt

European Patent Office

Office européen des brevets

(19)

(11) Veröffentlichungsnummer: **0 244 848**
**A1**

## (12) EUROPÄISCHE PATENTANMELDUNG

(21) Anmeldenummer: **87106561.1**

(22) Anmeldetag: **06.05.87**

(51) Int. Cl.⁴: **H01L 21/31** , H01L 21/90

(30) Priorität: **07.05.86 DE 3615451**

(43) Veröffentlichungstag der Anmeldung:
**11.11.87 Patentblatt 87/46**

(84) Benannte Vertragsstaaten:
**BE DE FR GB NL**

(71) Anmelder: **Siemens Aktiengesellschaft Berlin
und München
Wittelsbacherplatz 2
D-8000 München 2(DE)**

(72) Erfinder: **Fritzsche, Hansjörg, Dr.
Forstenrieder Allee 134
D-8000 München(DE)**
Erfinder: **Grewal, Virinder, Dr.
Karwendelstrasse 45
D-8017 Ebersberg(DE)**

(54) Verfahren zum Planarisieren von anorganischen, als Zwischenschichten bei Mehrlagenmetallisierung verwendbaren Isolationsschichten.

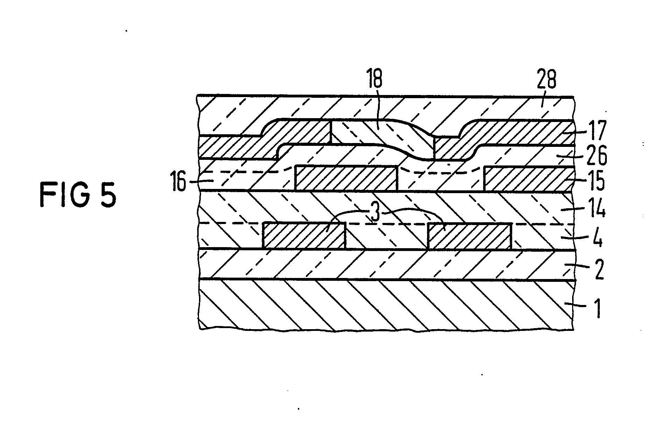

(57) Bei einem Verfahren zum Planarisieren der Oberfläche einer anorganischen Isolationsschicht (14) unter Verwendung einer organischen Hilfsschicht (10) und Rückätzverfahren (11) wird die auf die anorganische Isolationsschicht (4) flächendeckend aufgebrachte Hilfsschicht (10) in einer Magnetron-Trockenätzanlage mit Bereichen der darunterliegenden anorganischen Isolationsschicht (4) solange entfernt und mit einer weiteren anorganischen Isolationsschichtlage (4) wieder bedeckt, bis nach dem Rückätzverfahren eine ebene Oberfläche der anorganischen Isolationsschicht (4) entstanden ist. Dann wird die anorganische Isolationsschicht (14) bis auf ihre gewünschte Isolatordicke gebracht. Durch diesen Planarisierungsprozeß werden enge Spalte und Hohlräume in Isolationsschichten (14) bei Mehrlagenmetallisierungen (14, 26, 28 in Figur 5) auch im 1 μm-Strukturbereich und darunter sicher geschlossen. Das Verfahren wird verwendet bei der Herstellung hochintegrierter Halbleiterschaltungen mit mehrlagigem Verdrahtungsaufbau.

FIG 4

## Verfahren zum Planarisieren von anorganischen, als Zwischenschichten bei Mehrlagenmetallisierung verwendbaren Isolationsschichten.

Die Erfindung betrifft ein Verfahren zum Planarisieren der Oberfläche einer anorganischen Isolationsschicht, wie sie als Zwischenschicht für Mehrlagenmetallisierungen von hochintegrierten Halbleiterschaltungen verwendet wird, bei dem der Planarisierungsprozeß durch Mitwirkung einer organischen Hilfsschicht und eines Rückätzverfahrens unterstützt wird.

Die zunehmende Packungsdichte bei hochintegrierten Halbleiterschaltungen bringt, aufgrund der dadurch bedingten Verringerung der lateralen Strukturabmessungen ohne entsprechende Abnahme der Schichtdicke und der Zunahme der Verdrahtungsebenen, Probleme bei der Strukturierung und der Kantenbedeckung der Leiterbahnen mit sich. Zur Behebung dieser Schwierigkeiten ist, besonders bei mehr als drei Verdrahtungsebenen, eine möglichst weitgehende Einebnung der vorangehenden Leiterbahnebene(n) durch die diese isolierende Schicht notwendig.

Aufgabe der Erfindung ist es daher, ein Verfahren anzugeben, mit dem eine nahezu ebene Oberfläche nach der Herstellung der anorganischen Isolationsschicht erreicht wird. Insbesondere soll das Verfahren anwendbar sein für Strukturabstände kleiner 2 $\mu$m und Strukturhöhen kleiner 1 $\mu$m.

Aus dem J. Electrochem. Soc. 128 (1981) ist auf den Seiten 423 bis 429 aus einem Bericht von Adams und Capio ein Verfahren zur Einebnung bzw. Planarisierung einer anorganischen Isolationsschicht bekannt, welches auf dem Ätzen einer mit Photolack weitgehend eingeebneten Isolationsschicht bei gleicher Ätzrate für den Lack und das Isolationsmaterial beruht. Der Photolack wirkt dabei als Hilfsschicht. Der Planarisierungsprozeß wird als Rückätzprozeß bezeichnet. Begrenzt wird dieses Verfahren durch die Abscheidung der anorganischen Isolationsschicht(en), vor allem dann, wenn diese aus der plasmainduzierten Gasphase geschieht. Enge Spalte und Löcher werden nicht gefüllt. Bei entsprechendem Verhältnis von Leitbahnabstand und gewünschter Isolationsschichtdicke entstehen Kavernen, die bei dem Rückätzen geöffnet werden können und dann zu unzulässigen Anätzungen des Untergrundes führen.

Ein weiteres Verfahren, bei dem auch eine organische Hilfsschicht und ein Rückätzverfahren verwendet wird, ist aus der DE-OS 33 45 040 A1 bekannt. Bei diesem Verfahren erfolgt die Einebnung mit Hilfe einer Polyimidschicht, die auf die zu isolierende und mit der Metallisierung versehene Oberfläche aufgebracht und dann durch ein Trockenätzverfahren ganzflächig soweit wieder entfernt wird, bis die Metallisierung freigelegt ist. Erst dann wird darauf die anorganische Isolationsschicht bis zur gewünschten Isolatordicke abgeschieden. Dieses Verfahren hat den Nachteil, daß Polyimidinseln im Schichtaufbau verbleiben, welche zu Wechselwirkungen mit den anorganischen Isolationsschichten und den darunterliegenden Metallisierungen führen können. Außerdem ist auch hier nicht gewährleistet, daß keine Kavernen im Verlauf des Prozesses entstehen.

Eine sichere Auffüllung von Spalten und Kavernen wird nur durch das Verfahren nach der Lehre der Erfindung gewährleistet, welches erfindungsgemäß durch den Ablauf folgender Verfahrensschritte gekennzeichnet ist:

a) zunächst wird die anorganische Isolationsschicht konform auf dem metallisierten Substrat abgeschieden,

b) darauf wird die organische Hilfsschicht aufgebracht, bis eine ebene Oberfläche entsteht,

c) die organische Hilfsschicht und die darunterliegende anorganische Isolationsschicht werden solange mit der gleichen Ätzrate in einer Magnetron-Trockenätzanlage abgetragen, bis die organische Hilfsschicht wieder vollkommen entfernt ist,

d) eine weitere Lage der anorganischen Isolationsschicht und der organischen Hilfsschicht werden wie bei a) und b) aufgebracht und wie bei c) wieder entfernt,

e) der Vorgang wird solange wiederholt, bis nach dem Rückätzen eine ebene Oberfläche der anorganischen Isolationsschicht entsteht und

f) abschließend wird die anorganische Isolationsschicht durch Abscheidung von anorganischem Isolationsmaterial auf die gewünschte Isolatordicke gebracht.

Diese Prozeßführung löst das Problem auf einfache Weise, das heißt, es werden auch enge Spalte mit dem Isolationsmaterial aufgefüllt, da der Prozeß solange wiederholt wird, bis alle Spalte gefüllt sind, in die die obengenannten Schichten überhaupt abscheidbar sind. Durch die Verwendung der organischen Hilfsschicht und ihre vollständige Wiederentfernung durch Ätzung in der Magnetronätzanlage wird erreicht, daß die volle Spaltbreite erhalten bleibt und die anorganische Isolationsschicht im Spaltboden nicht gedünnt wird.

Weitere Ausgestaltungen der Erfindung ergeben sich aus den Unteransprüchen.

Durch das Verfahren nach der Lehre der Erfindung ist die Möglichkeit gegeben, höchstintegrierte Halbleiterschaltungen, insbesondere CMOS-Bausteine, mit mehr als drei Verdrahtungsebenen sogar auf unebenen Substraten und mit Strukturabständen kleiner 2 μm herzustellen. Elektromigrations-Effekte und Ätzrückstände treten nicht auf; die Lebensdauer für strombelastete Leiterbahnen wird verdreifacht.

Anhand der Figuren 1 bis 5 sollen weitere Einzelheiten der Erfindung noch näher erläutert werden. Dabei zeigt

die Figur 1 im Schnittbild einen Schichtaufbau mit ungenügender Planarisierung (Stand der Technik),

die Figuren 2 bis 4 in schematischer Darstellung den Prozeßablauf zur erfindungsgemäßen Planarisierung und

die Figur 5 im Schnittbild eine Dreilagenmetallisierung, wie sie durch das Verfahren nach der Lehre der Erfindung erhalten wird.

In allen Figuren sind gleiche Teile mit gleichen Bezugszeichen bezeichnet.

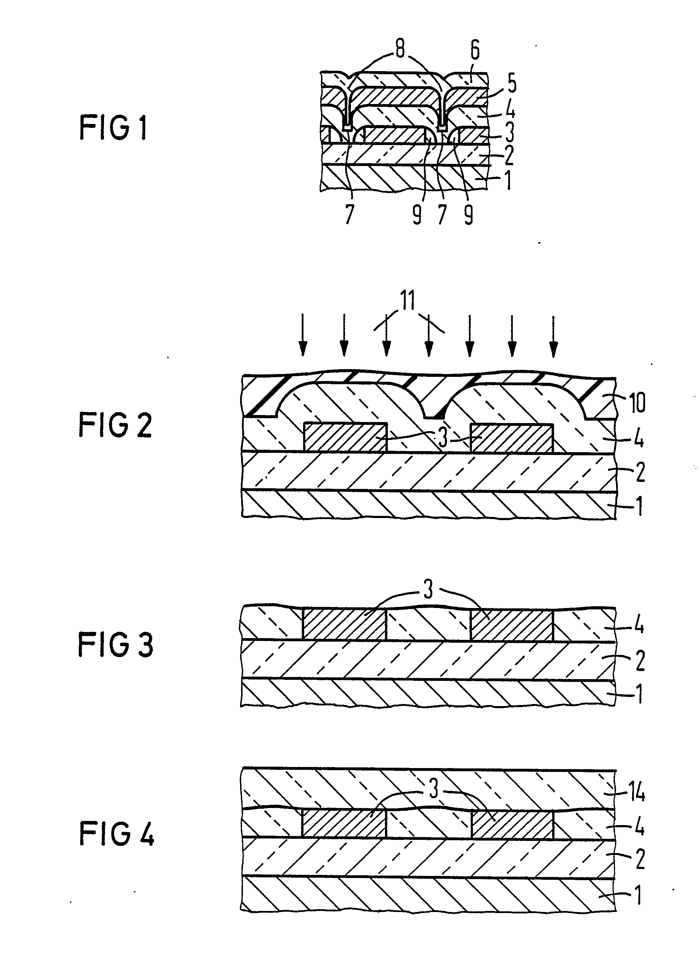

Figur 1 zeigt eine Zweilagenmetallisierung mit ungenügender Planarisierung. Dabei gelten folgende Bezugszeichen:

1 Siliziumsubstrat

2 Isolationsschicht, zum Beispiel Bor-Phosphor-Silikatglas

3 erste Metallisierung, zum Beispiel aus einer Aluminium/Silizium-Legierung

4 Zwischenoxidschicht ($SiO_2$)

5 zweite Metallisierung, zum Beispiel aus einer Aluminium/Silizium-Legierung

6 Passivierungsschicht, zum Beispiel aus Siliziumnitrid

7 Spalte unter der Zwischenoxidschicht 4

8 Spalte in der zweiten Metallisierung 5

9 Flankenoxid, bedingt durch die $SiO_2$-Abscheidung 4.

Wie aus der Figur 1 ersichtlich ist, werden die durch die erste Metallisierung 3 auf der Oberfläche bedingten Unebenheiten durch die Abscheidung der Zwischenoxidschicht 4 nicht ausgeglichen und erzeugen bei der Abscheidung der zweiten Metallisierung 5 tiefe Spalte 8.

Figur 2: Auf die zu isolierende und einzuebnende erste Metallisierung 3, zum Beispiel eine Aluminium/Silizium/Titan-Legierung, welche auf einem, mit einer $SiO_2$-Schicht 2, zum Beispiel Bor-Phosphor-Silikatglas, versehenem Siliziumsubstrat 1 strukturiert ist, wird ganzflächig konform, das heißt, ohne Hohlräume, Risse und Spalte, aus der plasmainduzierten Gasphase eine aus $SiO_2$ und/oder Siliziumnitrid bestehende Schicht 4 in einer Schichtdicke von zum Beispiel 3 bis 5 μm abgeschieden. Darauf wird flächendeckend eine Photolackschicht 10 in einer Schichtdicke von zum Beispiel 1 bis 2 μm aufgebracht und nach dem Aushärten bei 200°C (15 Minuten) durch Plasmaätzung 11 in einer Magnetron-Trockenätzanlage in einem zweistufigen Ätzprozeß entfernt.

Figur 3: Dabei wird in der ersten Stufe solange geätzt, bis die $SiO_2$-bzw. Siliziumnitrid-Schicht 4 wieder überall offengelegt ist. In der zweiten Stufe wird der Photolack 10 auf der Isolationsschicht 4 bis zu einem Endpunkt ($SiF_3$-Linien, kontrolliert mit der Emissionsspektrometrie) mit einer Ätzrate 1:1 geätzt bis kein Photolack (10) mehr auf der Oberfläche ist, die Isolationsschicht 4 aber zwischen der Metallisierung 3 noch vorhanden ist. Für die Ätzung in der Magnetrontrockenätzanlage gelten folgende Parameter:

1. Stufe: Ätzgas Sauerstoff, Gasfluß: 10 sccm (= Standardkubikzentimeter), Druck 2 Pa, Hochfre quenzleistung 2,5 kW, Ätzdauer: 40 Sekunden, Ätzrate 1 μm/min.

2. Stufe: Ätzgas Hexafluoräthan ($C_2F_6$) und Sauerstoff, Gasfluß: $C_2F_6$ 44 sccm, Sauerstoff 6 sccm, Druck 12 Pa, Hochfrequenzleistung 2,5 kW, Ätzdauer bis zum Endpunkt (Ätzzeit 0,4 bis 0,7 min).

Figur 4: Der Prozeß wird nun solange wiederholt, bis nach dem Rückätzen eine nahezu ebene Oberfläche der Isolationsschicht 4 entstanden ist. Dabei wird mit einer Plasmaoxid-bzw. -nitrid-Abscheidung wie in Figur 2 beschrieben begonnen, wobei immer eine weitere Auffüllung mit Isolationsmaterial stattfindet. Schließlich wird die restliche Schichtdicke der Isolationsschicht mit einer ganzflächigen Abscheidung 14 von $SiO_2$ bzw. Siliziumnitrid beendet. Die weitere und vollständige Mehrlagenmetallisierung ist aus Figur 5 ersichtlich.

Figur 5: Der besseren Übersicht wegen ist hier auf die Einzeichnung von Kontaktlöchern verzichtet worden. Es gelten die gleichen Bezugszeichen wie in den Figuren 1 und 4.

Mit dem Bezugszeichen 15 ist die zweite Metallisierung, mit 16 und 26 die zweite Zwischenoxidschicht, mit 17 die dritte Metallisierung und mit 18 und 28 die dritte Zwischenoxidschicht bzw. Passivierungsschicht bezeichnet.

Ein Vergleich der Figuren 1 und 5 zeigt deutlich die Vorteile des erfindungsgemäßen Verfahrens.

## Ansprüche

1. Verfahren zum Planarisieren der Oberfläche einer anorganischen Isolationsschicht, wie sie als Zwischenschicht für Mehrlagenmetallisierungen von hochintegrierten Halbleiterschaltungen verwendet wird, bei dem der Planarisierungsprozeß durch Mitwirkung einer organischen Hilfsschicht und eines Rückätzverfahrens unterstützt wird, **dadurch gekennzeichnet,** daß

a) zunächst die anorganische Isolationsschicht (4) konform auf dem metallisierten Substrat (1, 2, 3) abgeschieden wird,

b) darauf die organische Hilfsschicht (10) aufgebracht wird, bis eine ebene Oberfläche entsteht,

c) die organische Hilfsschicht (10) und die darunterliegende anorganische Isolationsschicht (4) mit der gleichen Ätzrate in einer Magnetron-Trockenätzanlage solange abgetragen werden, bis die organische Hilfsschicht (10) wieder vollkommen entfernt ist,

d) eine weitere Lage der anorganischen Isolationsschicht (4) und der organischen Hilfsschicht (10) wie bei a) und b) aufgebracht und wie bei c) entfernt wird,

e) der Vorgang solange wiederholt wird, bis nach dem Rückätzen eine ebene Oberfläche der anorganischen Isolationsschicht (4) entsteht und

f) abschließend die anorganische Isolationsschicht durch Abscheidung von anorganischem Isolationsmaterial (14) auf die gewünschte Isolatordicke gebracht wird.

2. Verfahren nach Anspruch 1, dadurch gekennzeichnet, daß die anorganischen Isolationsschichten (4, 14) durch Abscheidung aus der plasmainduzierten Gasphase aufgebracht werden.

3. Verfahren nach Anspruch 1 oder 2, dadurch gekennzeichnet, daß als Isolationsschichten (4, 14, 16, 26, 18, 28) $SiO_2$-und/oder Siliziumnitrid-Schichten verwendet werden.

4. Verfahren nach Anspruch 1, dadurch gekennzeichnet, daß als organische Hilfsschicht (10) Photolackschichten oder Polyimidschichten verwendet werden.

5. Verfahren nach Anspruch 4, dadurch gekennzeichnet, daß die organische Hilfsschicht (10) durch Aufschleudern und Aushärten erzeugt wird.

6. Verfahren nach einem der Ansprüche 1 bis 5, dadurch gekennzeichnet, daß der Trockenätzprozeß in zwei Stufen durchgeführt wird, wobei in der ersten Stufe mit Sauerstoff als Ätzgas die organische Hilfsschicht (10) bis zur Freilegung der anorganischen Isolationsschicht (4) entfernt wird und in der zweiten Stufe mit einem Fluor-Ionen und Sauerstoff enthaltenden Ätzgas solange geätzt wird, bis die organische Hilfsschicht (10) ganz entfernt ist.

7. Verfahren nach einem der Ansprüche 1 bis 6, dadurch gekennzeichnet, daß der Endpunkt des Ätzabtrages mittels optischer Emissionsspektrometrie bestimmt wird.

8. Verfahren nach einem der Ansprüche 1 bis 7, dadurch gekennzeichnet, daß die Prozeßfolge (a bis f gemäß Anspruch 1) für mehrere Metallisierungsebenen beliebig oft wiederholt wird (Figur 5).

**FIG 1**

**FIG 2**

**FIG 3**

**FIG 4**

FIG 5

# EUROPÄISCHER RECHERCHENBERICHT

**Europäisches Patentamt**

Nummer der Anmeldung

EP 87 10 6561

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | WO-A-8 504 623 (ADVANCED MICRO DEVICES INC.) <br> * Ansprüche 4-6 * | 1 | H 01 L 21/31 <br> H 01 L 21/90 |
| X | * Seite 9, Zeilen 25-29 * | 3 | |
| X | * Ansprüche 13-15 * | 8 | |
| X | --- <br> WO-A-8 404 996 (NCR CORP.) <br> * Anspruch 4 * | 2 | |
| X | * Seite 12, Zeilen 19-21 * | 7 | |
| Y | * Seite 12, Zeile 15 - Seite 13, Zeile 3 * | 6 | RECHERCHIERTE SACHGEBIETE (Int. Cl.4) <br><br> H 01 L |
| A | * Seite 12, Zeilen 10-19 * | 1 | |
| X | --- <br> EXTENDED ABSTRACTS, Band 83, Nr. 2, 9.-14. Oktober 1983, Seite 327, Princeton, US; K.H. OH et al.: "Bird's head smoothing by two-step plasma etch" <br> * Spalte 2, Zeilen 7-13 * | 5 | |
| | ---      -/- | | |

Der vorliegende Recherchenbericht wurde für alle Patentansprüche erstellt.

| Recherchenort | Abschlußdatum der Recherche | Prüfer |
|---|---|---|
| DEN HAAG | 29-07-1987 | PHEASANT N.J. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

Europäisches
Patentamt

**EUROPÄISCHER RECHERCHENBERICHT**

Nummer der Anmeldung

EP   87 10 6561

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | * Spalte 2, Zeilen 14-25 * | 6 | |
| | --- | | |
| X | EP-A-0 023 146   (FUJITSU)<br>* Anspruch 16 * | 4 | |
| | --- | | |
| X | EP-A-0 216 425   (RTC-COMPELEC)<br>* Anspruch 1 * | 7 | |
| | ----- | | |

RECHERCHIERTE
SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 29-07-1987 | PHEASANT N.J. |